# EUROPEAN PATENT APPLICATION

(11) **EP 2 027 970 A1**
(43) Date of publication of application: **25.02.2009**
(21) Application number: 07744044.4
(22) Date of filing: 24.05.2007
(51) Int. Cl.: B24B 37/00, C09K 3/14, H01L 21/304

(54) **POLISHING COMPOSITION AND POLISHING METHOD**

(30) Priority: 31.05.2006 JP 2006151477
(71) Applicant: Asahi Glass Company, Limited, Chiyoda-ku Tokyo 100-8405 (JP); AGC Seimi Chemical Co., Ltd., Chigasaki-shi, Kanagawa 253-8585 (JP)
(72) Inventor: KAMIYA, Hiroyuki, Tokyo 100-8405 (JP); TSUGITA, Katsuyuki, Chigasaki-shi Kanagawa 253-8585 (JP)
(74) Representative: Müller-Boré & Partner Patentanwälte
(86) International application number: PCT/JP2007/060610
(87) International publication number: WO 2007/138975

(57) **Abstract**

To provide a polishing compound which can satisfy both high removal rate of an object to be polished and excellent property to eliminate the difference in level, and to provide a polishing method which can polish a wiring metal fast while suppressing increase of a wiring metal resistance and is excellent in the property to eliminate the difference in level.

A polishing compound which comprises abrasive particles, an oxidizing agent, ammonium ions, polyvalent carboxylate ions, at least one chelating agent selected from the group consisting of pentaethylenehexamine, triethylenetetramine and tetraethylenepentamine, and an aqueous medium. Further, a polishing method of polishing a wiring metal 3 by using the polishing compound, after providing a wiring trench 2 on a resin substrate 1 and embedding the wiring metal 3 in the wiring trench 2.

## Description

### TECHNICAL FIELD

The present invention relates to a polishing compound and a polishing method.

### BACKGROUND ART

Recently, along with the progress in the integration and functionality of semiconductor devices, there has been a demand for development of micro-fabrication techniques for processes of producing the semiconductor devices. Particularly, planarization techniques for interlayer insulating films and embedded wirings are important in processes of forming multilayered wirings.

That is, as patterns are formed in insulating films or metal films, complex unevennesses are caused on the surface of a semiconductor wafer. The difference in level resulting from the unevennesses tends to increase as wirings are multilayered. Accordingly, if more patterns were formed on the semiconductor wafer, the depth of the focus in a lithographic method would become shallow for transferring patterns, resulting in a problem such that desired patterns would not be formed. Therefore, techniques to planarize the surface of the semiconductor wafer with high accuracy are needed.

CMP (Chemical Mechanical Polishing) has been used as one of such planarization techniques. The CMP method is used, for instance, when copper is embedded into an interlayer insulating film in a process of forming copper wiring by a Damascene method. Specifically, it is a technique to eliminate the difference in level on the surface of the semiconductor wafer by both chemical and mechanical actions. According to the technique, it is possible to remove convex portions, while controlling processing of concave portions.

Now, in semiconductor production processes, a technique related to a wiring board is one of the important elemental technologies. A wiring board plays a role to have semiconductor packages or bare chips mounted, supported and fixed thereon, and simultaneously, to establish an electrical connection between the packages and chips. Thus, by this technology, a materially stabilized highly dense multilayered wiring structure may be formed by combining various core materials of supporting boards, various conductive materials that work as electrically connecting wirings, and insulating materials that insulate between the respective signal wirings.

Depending on types of the base core materials, wiring boards may be generally classified into organic wiring boards and inorganic wiring boards. Organic wiring boards, which are represented by printed wiring boards, are used as mounted wiring boards for high-speed devices, since their dielectric constant is lower than that of inorganic wiring boards.

Conventional organic wiring boards are prepared, for instance, as disclosed in Patent Document 1. Namely, in a resin substrate, trenches for wiring circuits or holes for via hole connections are formed, and then, the trenches and the holes are filled with an electrical conductive material. Then, an excessive amount of the electrical conductive material is removed, and the surface is planarized by polishing. After that, bare chips are mounted on the resin substrate. In this case, polishing means mechanical polishing, which is carried out, for instance, by moving a polishing film coated with white alundum abrasive particles, on the resin substrate. However, the mechanical polishing has a risk of causing scratches on wiring metals or resin substrates, although it has an advantage of high removal rate.

On the other hand, in the above-mentioned CMP method, a slurry comprising abrasive particles and reagents, is used. The CMP method is a type of polishing wherein mechanical and chemical actions are used in combination, so that less scratch is caused as compared to the mechanical polishing. However, the conventional CMP method has had a problem that when it is used to produce organic wiring boards, the throughput decreases because of the low removal rate.

Here, with respect to the removal rate in the CMP method, a method is suggested to accelerate the removal rate by adding an inorganic ammonium salt to a polishing agent to shift the pH to an alkaline side (Patent Document 2). Further, a method of adjusting the removal rate of metal constituting a wiring metal layer or a barrier layer, by a polishing pressure and a polishing compound, is also suggested (Patent Documents 3 and 4).

However, all of these are targeting only the situation of forming metal wirings on semiconductor boards, like silicon wafers, but they do not discuss about the situation of forming metal wirings on a resin substrate, provided on a supporting board.

In addition, Patent Documents 3 and 4 describe about using a salt of an organic or inorganic acid with a basic compound, as an agent for adjusting the removal rate. However, the purpose of the agent for adjusting the removal rate is to lower the removal rate of a wiring metal layer, thereby to raise the polishing selectivity for a barrier metal layer, and accelerating the removal rate of a wiring metal layer is not described.

Whereas, to prevent scratches on a surface of a copper layer in a process of forming wiring boards by a build-up method, a method of polishing the copper layer by using a backing material that has a prescribed hardness and compressibility, is disclosed (Patent Document 5).

As disclosed, according to the method, it is possible to increase the removal rate and improve the throughput by using an amino acid as a copper chelating agent and further using a polishing solution that comprises a copper etching agent, a copper oxidizing agent and water.

The etching agent described in Patent Document 5 is one to etch a surface of a copper layer by chemical action, and it has a function to further accelerate polishing processing by mechanical action of polishing abrasive particles. Therefore, in order to increase the removal rate against the copper layer, it is effective to increase the etching rate, namely, the dissolution rate of copper. Specifically, it may be mentioned to increase the concentration of an electrolyte such as various organic acid, inorganic acid or ammonia, which is included in a polishing compound. However, in such a case, if the dissolution rate of copper is too high, copper of a wiring portion which is not supposed to be polished, may also be dissolved. If copper of a wiring portion dissolves, the thickness of wirings would be decreased, whereby there was a problem such that wiring resistance would be increased.

Further, with respect to the polishing compound having too high dissolution rate of copper, there was a problem such that the property to eliminate the difference in level would decrease. Such a point is described in detail as follows.

The property to eliminate the difference in level is a property to eliminate the unevennesses by polishing a surface having such unevennesses. More specifically, it is a property to reduce the difference in level of a convex portion and concave portion along with the progress of the polishing by relatively reducing the removal rate of a concave portion which is not supposed to be polished, as compared with the removal rate of a convex portion which is supposed to be polished. Such a property to eliminate the difference in level is one of important technical elements in wiring formation. However, in a case where a polishing compound having too high dissolution rate of copper, is used, a convex portion will be polished with a high removal rate, and at the same time, the removal rate at a concave portion will also be high, whereby it will be difficult to eliminate the unevennesses. Therefore, with respect to such a polishing compound, there was a problem such that the property to eliminate the difference in level was poor.

Patent Document 5 describes that in a case where the amount of an etching agent to be added is smaller than a prescribed value, no adequate removal rate will be obtained. However, in a case where the amount to be added is larger than the prescribed value, Patent Document 5 describes only that the etching agent may be precipitated, and does not mention about the increase of the wiring resistance by dissolution of copper of a wiring portion or about the problem of the property to eliminate the difference in level.

On the other hand, Patent Document 6 describes polishing of a semiconductor device containing a copper film and a tantalum compound film, and it mentions a problem such that since the removal rate of a copper film is higher than the removal rate of a tantalum compound film, a surface defect such as recess, dishing or erosion is caused. Further, according to Patent Document 6, it is possible to polish the tantalum compound film at a high removal rate by a compound for polishing obtained by dissolving a polishing agent, an oxidizing agent and a reducing agent, and if necessary, a chelating compound, in water. However, Patent Document 6 does not mention or indicate about the above increase of the wiring resistance or about the problem of the property to eliminate the difference in level.
Patent Document 1: JP-A-2003-197806
Patent Document 2: JP-A-2001-110761
Patent Document 3: JP-A-2003-286477
Patent Document 4: JP-A-2003-297779
Patent Document 5: JP-A-2003-257910
Patent Document 6: JP-A-2000-160139

### DISCLOSURE OF THE INVENTION

### OBJECTS TO BE ACCOMPLISHED BY THE INVENTION

The present invention has been accomplished in view of such problems. That is, an object of the present invention is to provide a polishing compound which can satisfy both a high removal rate of an object to be polished and an excellent property to eliminate the difference in level.

Further, an object of the present invention is to provide a polishing method which can polish a wiring metal with a high removal rate while suppressing an increase of a wiring resistance, and which is excellent in the property to eliminate the difference in level.

Other objects and advantages of the present invention will be apparent by the following description.

### MEANS TO ACCOMPLISH THE OBJECTS

The polishing compound of the present invention is a polishing compound which comprises abrasive particles, an oxidizing agent, ammonium ions, polyvalent carboxylate ions, at least one chelating agent selected from the group consisting of pentaethylenehexamine, triethylenetetramine and tetraethylenepentamine, and an aqueous medium.

The above chelating agent preferably has a concentration of from 0.0005 mol/kg to 0.05 mol/kg.

The above ammonium ions preferably have a concentration of at least 0.3 mol/kg.

The above polyvalent carboxylate ions preferably have a concentration of from 0.05 mol/kg to 0.5 mol/kg.

The above polyvalent carboxylate ions preferably include citrate ions.

The above abrasive particles are preferably α-alumina.

The above oxidizing agent is preferably hydrogen peroxide.

The polishing compound of the present invention may further contain at least one type of ions selected from the group consisting of carbonate ions, hydrogencarbonate ions, sulfate ions and acetate ions.

In such a case, the concentration of one type of ions selected from the above group or the sum of the concentrations of at least two types of ions selected from the above group is preferably from 0.01 mol/kg to 0.2 mol/kg.

Such ions may be contained in the polishing compound of the present invention by adding at least one member selected from the group consisting of ammonium carbonate, ammonium hydrogencarbonate, ammonium sulfate and ammonium acetate.

The polishing compound of the present invention preferably has a pH of from 6 to 10.

The polishing compound of the present invention may further contain a copper surface protective agent.

The polishing method of the present invention is one to polish a wiring metal by using the above polishing compound.

The above wiring metal may be either one of copper and a copper alloy.

The above wiring metal may be one provided on a resin substrate.

### EFFECTS OF THE INVENTION

The polishing compound of the present invention contains ammonium ions, polyvalent carboxylate ions, and at least one chelating agent selected from the group consisting of pentaethylenehexamine, triethylenetetramine and tetraethylenepentamine, whereby it can satisfy both the high removal rate of an object to be polished and excellent property to eliminate the difference in level.

According to the polishing method of the present invention, a wiring metal is polished by using the polishing compound of the present invention, whereby it is possible to increase the removal rate while suppressing an increase of the wiring resistance, and it is possible to obtain the excellent property to eliminate the difference in level.

Further, according to the polishing method of the present invention, polishing is carried out by mechanical and chemical actions, whereby it is possible to reduce formation of scratches on a wiring metal as compared with mechanical polishing.

### BRIEF DESCRIPTION OF DRAWINGS

Fig. 1 is a schematic sectional side view showing a resin substrate provided on a supporting board.
Fig. 2 is a view illustrating the polishing method using the polishing compound of the present invention.
Fig. 3 is a schematic sectional side view showing a wiring board to be produced by the present invention.
Fig. 4(a) is a schematic sectional view of a part of an object to be polished before polishing in Examples of the present invention, and (b) is a schematic sectional view of a part of an object to be polished during the polishing.
Fig. 5 is a graph showing an evaluation of the property to eliminate the difference in level of a portion of the difference in level 1.
Fig. 6 is a graph showing an evaluation of the property to eliminate the difference in level of a portion of the difference in level 2.
Fig. 7 is a graph showing an evaluation of the property to eliminate the difference in level of a portion of the difference in level 3.

### MEANINGS OF SYMBOLS.

- 1: Resin substrate,
- 2: Wiring trench
- 3: Wiring metal
- 3a: A broad surface portion of a board where no wiring trench is formed.
- 3b: A portion where wiring trenches are formed.
- 4: Wiring board
- 5: Supporting board

### BEST MODE FOR CARRYING OUT THE INVENTION

As mentioned above, it is possible to increase the removal rate of the wiring metal by increasing the concentration of an electrolyte contained in the polishing compound, such as various organic acid, inorganic acid or ammonia. However, the removal rate and the property to eliminate the difference in level are in a trade-off relationship, whereby by simply increasing the amount of the electrolyte, the removal rate can be increased, but the property to eliminate the difference in level will decrease. Further, since copper of a wiring portion which is not supposed to be polished, will also be polished at a high rate, it may result in an increase of a wiring resistance. Such a point will be described in further detail.

In a polishing step, a part of polished wiring metal becomes ionized and dissolves in the polishing compound. The dissolved metal ions will act as a catalyst, and they may cause decomposition of an oxidizing agent or runaway of the oxidization reaction. For example, when the wiring metal is copper, it is known that copper ions become a catalyst and cause a decomposition reaction of hydrogen peroxide. Radicals generated by such a decomposition reaction, show a strong oxidizing effect, whereby dissolution of the wiring metal will be accelerated. Particularly, in a system having a high concentration of an electrolyte in the polishing compound, many metal ions are present, whereby dissolution of the wiring metal will be further accelerated. Consequently, it is possible to increase the removal rate, but the removal rate of copper in a wiring portion or a concave portion will also be high, which may cause increase of a wiring resistance or decrease of the property to eliminate the difference in level.

Therefore, the present inventors have conducted extensive studies to obtain a polishing compound which can satisfy both a high removal rate and an excellent property to eliminate the difference in level. As a result, they have found that the above object can be achieved by a polishing compound containing at least one chelating agent selected from the group consisting of pentaethylenehexamine, triethylenetetramine and tetraethylenepentamine, and an electrolyte which generates ammonium ions and polyvalent carboxylate ions.

When the chelating agent is added in the polishing compound, metal ions formed by dissolution of a wiring metal, will be bonded with the chelating agent to form a stable complex. Therefore, it is considered that the above decomposition reaction of the oxidizing agent is thereby suppressed.

On the other hand, adding ammonium ions or polyvalent carboxylate ions is effective for increasing the removal rate of the wiring metal.

Accordingly, by using them together, it is possible to suppress an excess increase of the removal rate while attempting to increase the removal rate, on the other hand. Therefore, by the polishing compound of the present invention, it is possible to satisfy both the high removal rate and the excellent property to eliminate the difference in level. Further, it is possible to suppress polishing of a wiring portion, whereby it is also possible to suppress increase of a wiring resistance.

Further, Patent Document 6 discloses a polishing compound containing a polishing agent, an oxidizing agent, a reducing agent and water. Further, it is disclosed that, to such a polishing compound, it is possible to add a chelating agent which shows chelating effect to copper, as the case requires. However, Patent Document 6 has an object to provide a polishing compound having a high removal rate of a tantalum compound film and a low removal rate of an insulating film such as a silicon dioxide film. Therefore, the chelating agent is added to improve the removal rate of a copper film having a large amount to be polished.

On the other hand, the present invention has an object to satisfy both improvement of the removal rate and improvement of the property to eliminate the difference in level, and thus, it has a object different from Patent Document 6 which is concerned only with the removal rate ratio of the tantalum compound film and the insulating film. Therefore, while improvement of the removal rate of a copper film is attempted by adding the chelating agent in Patent Document 6, the improvement is attempted in the present invention mainly by ammonium ions and polyvalent carboxylate ions. Further, the chelating agent in the present invention is used for the purpose of suppressing a decomposition reaction of the oxidizing agent and preventing an excess increase of the removal rate of a wiring metal. Therefore, by the polishing compound of the present invention, the removal rate becomes lowered as compared with a case where no chelating agent is added, but it is possible to achieve an excellent property to eliminate the difference in level. Moreover, it is possible to achieve a higher removal rate, particularly, a removal rate of at least 1.2 µm/min, as compared with Patent Document 6 which has an object to simply improve the removal rate of an insulating film.

Now, the polishing compound of the present invention will be described in further detail with reference to specific examples.

Abrasive particles are ones to carry out polishing by a mechanical action. Usually, as abrasive particles become larger in the particle size and harder, it is possible to increase the removal rate. However, on the other hand, polishing scratches may easily be formed on the surface of an object to be polished. Therefore, it is important to select abrasive particles having a proper particle size and hardness, by comparing and taking the removal rate and polishing scratches into a consideration.

In the present invention, a wiring metal of e.g. copper provided on a resin substrate is an object to be polished. Therefore, as is different from a case of polishing a semiconductor substrate, it is possible to select abrasive particles by placing priority on an improvement of the removal rate over suppressing polishing scratches. Accordingly, as compared with a case of polishing the semiconductor substrate, in the present invention, the average particle size of abrasive particles is preferably large, and the abrasive particles are preferably hard. Further, even under such conditions, since polishing is carried out by mechanical and chemical actions in combination in the present invention, it is possible to minimize formation of scratches on an object to be polished, as compared with polishing carried out by only a mechanical action.

The abrasive particles in the present invention may, for example, be an aluminum oxide such as α-alumina (α-Al₂O₃), β-alumina (β-Al₂O₃), δ-alumina (δ-Al₂O₃), γ-alumina (γ-Al₂O₃) or θ-alumina (θ-Al₂O₃) ; cerium oxide (CeO₂); silicon dioxide (SiO₂); titanium oxide (TiO₂); zirconium oxide (ZrO₂). However, such abrasive particles are not limited to be used individually, but it is possible to use them in a combination as a mixture of two or more of them.

Especially, in the present invention, α-alumina is preferred from the viewpoint of a low price and capability of increasing the removal rate. For example, it is possible to use α-alumina having an average particle size of about 1 µm by adding it in a concentration of from 2.5 wt% to 3.0 wt% based on the total weight of the polishing compound.

The abrasive particles are present in a state as dispersed in an aqueous medium in the polishing compound. The aqueous medium may, for example, be high purity water such as deionized water, or one containing water as a main component and an organic solvent soluble in the water. Here, the organic solvent may, for example, be a C₁₋₅ lower alcohol such as methanol, ethanol, propanol, butanol or ethylene glycol.

In the present invention, by adding an oxidizing agent to the polishing compound, it is possible to accelerate polishing. Specifically, by an effect of the oxidizing agent, an oxidized film will be formed on the surface of a wiring metal as an object to be polished. And, polishing will be accelerated by removing such an oxidized film from the surface of a resin substrate by a mechanical force, or by having the wiring metal ionized into ions by an action of the oxidizing agent and dissolved in the polishing compound.

In the present invention, the concentration of the oxidizing agent in the polishing compound is preferably in a range of from 0.1 mol/kg to 10 mol/kg, particularly preferably in a.range of from 0.5 mol/kg to 5 mol/kg.

The oxidizing agent may, for example, be hydrogen peroxide, urea peroxide, peracetic acid, iron nitrate or iodate. Particularly, it is preferred to use hydrogen peroxide from such a viewpoint that it is thereby possible to reduce contamination by a heavy metal or organic product to the wiring substrate.

As the chelating agent, at least one member selected from the group consisting of pentaethylenehexamine, triethylenetetramine and tetraethylenepentamine, is used. However, the chelating agent may be any one so long as it shows a chelating effect to copper, and it is possible to further add a chelating agent other than those mentioned above. In such a case, the chelating agent may, for example, be ethylenediamine diethylenetriamine, hexaethyleneheptamine, ethylenediamine tetraacetate, diethylenetriamine, pentaacetate, triethylenetetramine hexaacetate or nitrilotriacetate. Among them, a polyamine having a nitrogen atom in its molecule, such as ethylenediamine, ethylenetriamine, triethylenetetramine, tetraethylenepentamine, pentaethylenehexamine or hexaethyleneheptamine, is preferred, since it has a proper bonding energy with copper ions. Further, if the molecular weight of the chelating agent is small, the property to eliminate the difference in level may be lowered, and if the molecular weight is large, solubility of the chelating agent will decrease, whereby stability of the polishing compound may be poor. Therefore, triethylenetetramine, tetraethylenepentamine or pentaethylenehexamine, having a proper molecular weight, is more preferred.

The chelating agent is preferably contained in the polishing compound in a concentration of from 0.0005 mol/kg to 0.05 mo/kg, particularly preferably in a concentration of from 0.001 mol/kg to 0.01 mol/kg. With respect to pentaethylenehexamine, triethylenetetramine and tetraethylenepentamine, they may, respectively, be adjusted to the above concentration range individually. Further, when at least two chelating agents are contained in the polishing compound in combination, the sum of the concentrations of the respective chelating agents can be adjusted to the above range. If the concentration of the chelating agent is too low, it will not be possible to sufficiently suppress decomposition of the oxidizing agent, whereby the property to eliminate the difference in level may be decreased. On the other hand, if the concentration of the chelating agent is too high, the removal rate may be lowered.

Ammonium ions play a role to chemically etch a wiring metal as an object to be polished. The ammonium ions are preferably contained in the polishing compound in a concentration of at least 0.1 mol/kg, particularly preferably in a concentration of at least 0.3 mol/kg. If the concentration becomes lower than 0.1 mol/kg, a sufficient removal rate may not sometimes be obtained. Further, the ammonium ions are preferably contained in the polishing compound in a concentration of at most 2.5 mol/kg from the viewpoint of stability.

When copper wirings are to be formed in an interlayer insulating film on a semiconductor board, it is necessary to form a diffusion barrier film such as a tantalum (Ta) film or tantalum nitride (TaN) film for preventing diffusion of copper. In such a case, if the concentration of the ammonium ions becomes high, the removal rate of tantalum will be accelerated, and the polishing selectivity for copper will be low. Therefore, the ammonium ions need to be at a concentration where the removal rate of tantalum will not be too high.

On the other hand, in a process for producing a wiring board, because no diffusion barrier film is formed, it is not necessary to consider the above problem. Therefore, within a range not to deteriorate other properties, it is possible to incorporate more ammonium ions as compared with the case where a diffusion barrier film is formed.

In the present invention, as a source for the ammonium ions, inexpensive aqueous ammonia is particularly preferably used. Further, it is possible to use an inorganic salt such as an ammonium salt. Furthermore, it is possible to supply carbonate ions, hydrogencarbonate ions, sulfate ions or acetate ions in the form of an ammonium salt.

The polyvalent carboxylate ions have the same effect as the ammonium ions, which is to chemically etch a wiring metal as an object to be polished. Further, they have an effect of improving the property to eliminate the difference in level by suppressing dishing. Here, the dishing means a state such that when forming a metal-embedded wiring, a center portion of the wiring becomes caved as a result of excessive polishing at a wide portion of the wiring. By incorporating the polyvalent carboxylate ions in the polishing compound, it is possible to substantially avoid such a problem.

The polyvalent carboxylate ions may, for example, be oxalate ions (C₂O₄²⁻), maleate ions (C₄H₂O₄²⁻), succinate ions (C₄H₄O₄²⁻), tartarate ions (C₄H₂O₆⁴⁻), citrate ions (C₆H₅O₇³⁻) or malate ions (C₄H₄O₅²⁻). Citric acid is preferably used from a viewpoint such that it is thereby possible to obtain an excellent property to eliminate the difference in level and it is inexpensive. Further, it is possible to use a polyvalent carboxylic acid such as malonic acid (CH₂(COOH)₂), glutaric acid ((CH₂)₃(COOH)₂) or adipic acid ((CH₂)₄(COOH)₂). The above exemplified materials may be used alone or in combination as a mixture of two or more of them.

In the polishing compound of the present invention, the polyvalent carboxylate ions are, irrespective of the valence, contained in a concentration of preferably at least 0.01 mol/kg, particularly preferably in a concentration of from 0.05 mol/kg to 0.5 mol/kg. If the concentration of the polyvalent carboxylate ions becomes lower than 0.01 mol/kg, the effect of the present invention will not be obtained. On the other hand, if the concentration of the polyvalent carboxylate ions exceeds 0.5 mol/kg, no substantial change in the removal rate will be observed.

In the polishing compound of the present invention, at least one type of ions selected from the group consisting of carbonate ions, hydrogencarbonate ions, sulfate ions and acetate ions, may be contained. By the presence of such ions, it is possible to further improve the removal rate.

The carbonate ions, hydrogencarbonate ions, sulfate ions and acetate ions are, irrespective of the valence, preferably contained in the polishing compound in a concentration of from 0.005 mol/kg to 1.0 mol/kg, particularly preferably in a concentration of from 0.01 mol/kg to 0.2 mol/kg. If the concentration is lower than 0.005 mol/kg, no substantial effect of improving the removal rate will be obtained. On the other hand, if the concentration is higher than 1.0 mol/kg, the viscosity of the polishing compound will increase, whereby the polishing characteristic will be deteriorated, such being undesirable.

Further, the carbonate ions, hydrogencarbonate ions, sulfate ions and acetate ions may, respectively, be adjusted to the above concentration range individually. Further, when at least two types of ions are contained in the polishing compound in combination, the sum of the concentrations of the respective ions may be adjusted to the above range. Furthermore, the concentration of ions are not related to the valence of the ions. For example, the polishing compound may contain either carbonate ions or hydrogencarbonate ions in the above concentration range. Otherwise, the polishing compound may contain both carbonate ions and hydrogencarbonate ions. In such a case, the sum of the concentrations of the carbonate ions and hydrogencarbonate ions is adjusted to the above range.

In the present invention, the carbonate ions, the hydrogencarbonate ions, the sulfate ions and the acetate ions can be used in the form of ammonium salts, such as ammonium carbonate ((NH₄)₂CO₃), ammonium hydrogencarbonate (NH₄HCO₃), ammonium sulfate ((NH₄)₂SO₄) and ammonium acetate (CH₃COONH₄). However, they are not limited to ammonium salts, but they may be other basic compounds, such as potassium salts.

Further, the polishing compound of the present invention preferably contains a surface protective agent which has a function to form a protective film on the surface of a wiring metal (particularly, copper or a copper alloy), to prevent dishing of the wiring metal portion.

The surface protective agent may, for example, be BTA (benzotriazole), TTA (tolyl triazole) or benzotriazole-4-carboxylic acid. Further, 1H-tetrazole, 5-amino-1H-tetrazole, 5-methyltetrazole, thiourea, salicylaldoxime or catechol may also be used.

For example, when the wiring metal is copper, such a substance may be physically and chemically adsorbed thereon to form a coating on the surface of the copper thereby to suppress copper elution. Moreover, the above substances can be used individually or in a combination of two or more of them.

In a case where BTA is used as the surface protective agent, BTA is contained in the polishing compound at a concentration of preferably from 0.0005 mol/kg to 0.05 mol/kg, particularly preferably from 0.001 mol/kg to 0.02 mol/kg. If the concentration is less than 0.0005 mol/kg, no adequate effect of the surface protective agent will be obtained. On the other hand, if the concentration becomes higher than 0.05 mol/kg, the removal rate will be decreased, such being undesirable.

Further, the polishing compound of the present invention may contain a pH adjusting agent, a surfactant, etc., if necessary.

In order to prevent oxidation of copper as an object to be polished, the polishing compound of the present invention preferably has a pH of at least 6, and specifically, the pH is preferably in a range of from 6 to 10, more preferably in a range of from 7.5 to 9.5, further preferably in a range of from 8 to 9.5. In the present invention, the pH may be adjusted by the amounts of the acid and ammonium ions to be incorporated in the polishing compound, but it is also possible to adjust the pH by adding a pH adjusting agent. In this case, the amount of the pH adjusting agent is not limited as long as it does not impair the polishing performance.

As the pH adjusting agent, a suitable acid or alkali may be used, but it is required to be such that the concentration of the carbonate ions, the hydrogencarbonate ions, the sulfate ions, the acetate ions or the ammonium ions in the polishing compound, should not depart from the range specified by the present invention.

For example, as the pH adjusting agent to adjust the pH toward the acidic side, nitric acid may, for example, be used and to adjust the pH toward the basic side, an alkali metal compound such as potassium hydroxide may, for example, be used.

The surfactant may be used to improve dispersibility of the polishing compound or to prevent roughening of the surface of the wiring metal after the polishing. In the present invention, any of an anionic surfactant, a cationic surfactant, a nonionic surfactant or an amphoteric surfactant may be used.

However, it is required that the concentration of the carbonate ions, the hydrogencarbonate ions, the sulfate ions, the acetate ions or the ammonium ions in the polishing compound, should not depart from the range specified by the present invention.

For example, as the surfactant, it is possible to use an anionic surfactant such as polyacryl acid or an alkylbenzenesulfonate; a nonionic surfactant such as a polyoxyethylene derivative, a polyoxyethylene sorbitan fatty acid ester or a glycerol fatty acid ester; or an amphoteric surfactant such as an alkylbetain.

The polishing compound of the present invention may further contain trishydroxymethyl aminomethane, and in such a case, it is possible to further improve the property to eliminate the difference in level. The concentration of trishydroxymethyl aminomethane is preferably at least 0.05 mol/kg, particularly preferably from 0.15 to 0.35 mol/kg. However, if it is incorporated in a large amount, the effect will become saturated, thus it is preferably at most 0.5 mol/kg.

Now, the polishing method using the polishing compound of the present invention will be described.

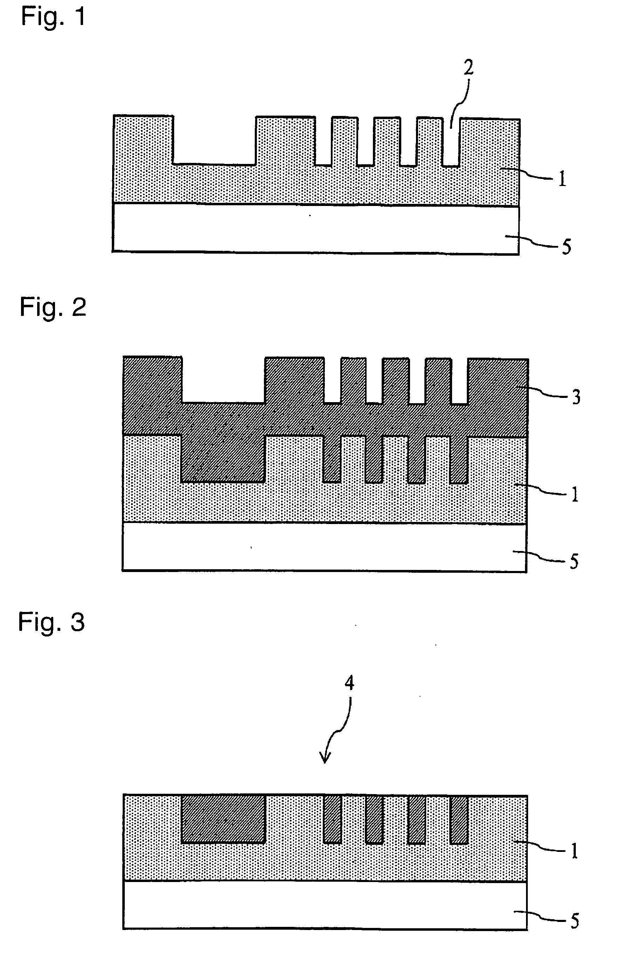

Figs. 1 to 3 show an example for producing a wiring board by using the polishing compound of the present invention. Further, portions identified by the same symbols mean the same portions.

First, as shown in Fig. 1, by using a laser beam machine, a wiring trench 2 as an opening portion is formed at a prescribed place on a resin substrate 1 which is provided on top of a supporting board 5.

The resin substrate 1 is made of an insulating material that preferably consists of a thermoplastic resin, a thermosetting resin or a mixture of them. Particularly, it is possible to use a thermoplastic resin having a relatively high heat resistance such as PEEK (polyetherether ketone), PEK (polyether ketone), PEI (a polyetherimide), a polyimide or PPS (polyphenylene sulfide); a thermosetting resin such as a polyester, an epoxy resin, a polyurethane, a phenolic resin or an acrylic resin; or a mixture obtained by mixing the above thermoplastic resin into the thermosetting resin such as glass epoxy prepreg material such as a FR4 or FR5. Here, although the thickness of the substrate is not particularly limited, it may, for example, be a film having a thickness of from 50 µm to 200 µm.

Then, as Fig. 2 shows, a wiring metal 3 is embedded in the wiring trench 2. In the present invention, copper is preferably used as the wiring metal 3. Embedding copper is carried out, for example, by forming a copper film as a seed copper by a sputtering method, followed by plating.

In Fig. 2, unevennesses are formed by the wiring metal 3 on the resin substrate 1. Therefore, by the polishing using the polishing compound of the present invention, an excessive amount of the wiring metal 3 on the resin substrate 1 is removed.

In the polishing process, the object to be polished is the wiring metal 3, so the polishing amount depends on the film thickness of the wiring metal 3. Therefore, to improve the throughput, it is important to accelerate the removal rate of the wiring metal 3.

Further, in general, in processes for producing a wiring board, a demand for flatness of the surface of the board will be lower as compared to the case for forming multiplayer wirings on a semiconductor board. Consequently it is not necessary to carry out a two-step polishing wherein, for example, the most part of the wiring metal is removed first at a high removal rate, and then the polishing condition will be changed to remove the rest of the wiring metal, and it is possible to remove the wiring metal in one step polishing without changing the condition.

In the present invention, the polishing method is not particularly limited. For example, while holding the back of a supporting board with a rotatable polishing head and pressing the surface to be polished (the side where the wiring metal is formed) to a polishing pad fixed to a rotatable support, it is possible to carry out the polishing by rotating the polishing head and the support. Otherwise, by fixing the back of the supporting board on the rotatable support, and pressing the polishing pad attached to the polishing head, to the surface to be polished, it is possible to carry out the polishing by rotating the polishing head and the support. In these cases, the polishing is carried out by supplying the polishing compound of the present invention between the surface to be polished and the polishing pad.

Further, it is possible to carry out the polishing by using a cushioning material between the support and the supporting board to relief the pressure exerted on the supporting board during the polishing, and to exert the pressure uniformly on the surface to be polished. Further, channels or feed orifices may be provided in the polishing pad to supply the polishing compound uniformly to the surface to be polished.

The material for the polishing pad, may, for example, be polyester or polyurethane. However, it is not limited thereto, but it may be suitably selected for use depending on the polishing compound to be used.

In general, if the polishing pressure is increased, it is possible to accelerate the removal rate, but damage on the object to be polished will be greater. For example, in a case of polishing an insulating film, which is formed on a semiconductor board, if the polishing pressure becomes high, the insulating film will have a greater risk of being separated from the semiconductor board. Therefore, it is important to determine the polishing pressure in consideration and comparison of mainly the removal rate and the damage that it may cause to the object to be polished.

In the present invention, the wiring metal such as copper is the object to be polished. Therefore, as compared to the case of polishing an insulating film, it is possible to determine the polishing pressure giving a priority to improvement of the removal rate. Further, even under such a condition, in the present invention, the polishing is carried out by both mechanical and chemical actions, whereby it is possible to minimize formation of scratches as compared to the polishing carried out by only a mechanical action.

Thus, according to the polishing compound of the present invention, it is possible to obtain a high removal rate even if the polishing pressure is low. Moreover, by increasing the polishing pressure, it is possible to further accelerate the removal rate more. Further, in this case, it is preferred to set a specific polishing pressure depending upon the type of the polishing pad, the presence or absence of a cushion material as well as its material, and the viscosity of the polishing compound.

Upon completion of the polishing, a wiring board 4 having a structure of Fig. 3 will be obtained. Then, it is preferred to wash the wiring board 4 to remove components of the polishing agent adsorbed on its surface. Other than the washing by running water, the washing can be carried out by scrub washing by a brush or ultrasonic cleaning.

As mentioned above, according to the polishing compound of the present invention, the polishing is carried out by both chemical and mechanical actions, and it is possible to minimize formation of scratches on a resin substrate and a wiring metal. Further, it is particularly preferred to carry out polishing of metal wiring patterns provided on the resin substrate. Further, it is possible to increase the removal rate at the wiring metal, whereby it is also possible to improve throughput in the process for producing a wiring board. Further, in such a case, the removal rate of the wiring portion or concave portion is controlled not to be too high, whereby it is possible to suppress the increase of the wiring resistance, and it is possible to obtain the excellent property to eliminate the difference in level.

Further, the present invention is not limited to the above embodiments, but various modifications may be made without departing from the scope of the present invention.

### EXAMPLES

Now, Examples and Comparative Examples of the present invention will be described. Further, Examples 1, 4 and 5 are Examples of the present invention, and Examples 2 and 3 are Comparative Examples.

### <POLISHING COMPOUNDS>

As polishing compounds, those shown in a Table 1 were used.

**TABLE 1**

| | α-alumina mass% | Hydrogen peroxide mol/kg | Ammonium ions mol/kg | Citric acid mol/kg | Carbonate ions mol/kg | Chlorine ions mol/kg | BTA mol/kg | PEHA mol/kg | Trishydroxymethyl aminomethane mol/kg | Water | pH |
|---|---|---|---|---|---|---|---|---|---|---|---|
| Ex.1 | 2.77 | 0.68 | 0.85 | 0.24 | 0.000 | 0.26 | 0.0078 | 0.0040 | 0.23 | Rest | 8 |
| Ex.2 | 2.77 | 0.68 | 1.13 | 0.24 | 0.000 | 0.52 | 0.0000 | 0.0000 | 0.23 | Rest | 8 |
| Ex.3 | 2.77 | 0.68 | 0.68 | 0.24 | 0.000 | 0.09 | 0.0078 | 0.0000 | 0.23 | Rest | 8 |
| Ex.4 | 2.77 | 0.68 | 1.02 | 0.24 | 0.000 | 0.26 | 0.0078 | 0.0040 | 0.00 | Rest | 8 |
| Ex.5 | 2.77 | 0.68 | 0.70 | 0.24 | 0.024 | 0.00 | 0.0093 | 0.0079 | 0.00 | Rest | 8 |

| | | | | | | | | | | | |
|---|---|---|---|---|---|---|---|---|---|---|---|
| * All α-alumina has an average particle size of 1 µm (manufactured by Wako Pure Chemical Industries, Ltd.) * BTA: Benzotriazole * PEHA: Pentaethylenehexamine | | | | | | | | | | | |

### <OBJECT TO BE POLISHED>

As the supporting board, a metal wafer having a thickness of 500 µm and a diameter of 6 inches was used, and on the wafer, a resin substrate having a thickness of 50 µm was laminated. Then, on the resin substrate, a wiring trench having a depth of 23 µm as an opening was formed. Further, on top of it, a copper film having thickness of 30 µm was formed by plating. Such a wafer was used as a pattern wafer for evaluating the property to eliminate the difference in level.

Further, not in the same manner as above, after the resin substrate was laminated on the metal wafer, a wiring trench was not formed, and a copper film having a film thickness of 30 µm was formed by plating. Such a wafer was used as a blanket wafer for measuring the removal rate.

### <POLISHING CONDITIONS>

The polishing was carried out under the following conditions.

Polishing machine: Polishing machine 6EC, manufactured by Strasbaugh

Polishing pad: IC-1400 K-Groove, manufactured by Rodel Inc.

Polishing compound supply amount: 200 mL/min

Polishing pressure: 4.1×10⁴ Pa

Number of revolutions of polishing pad: Polishing head (wafer holding portion) 97 rpm, platen (polishing platen) 103 rpm

### <EVALUATION OF REMOVAL RATE>

The results of comparing the removal rates are shown in Table 2. Further, the removal rates were obtained by polishing a blanket wafer for 60 seconds, and by measuring the film thickness of the copper film before and after polishing by a film thickness measuring apparatus (RT80-RG80, manufactured by NAPSON Corporation).

**TABLE 2**

| | Removal rate (µm/min) |
|---|---|
| Example 1 | 2 |
| Example 2 | 13 |
| Example 3 | 6 |
| Example 4 | 3 |
| Example 5 | 7 |

From Table 2, it is evident that in Examples 1, 4 and 5 of the present invention, a decrease in the removal rate was observed as compared with Examples 2 and 3 as Comparative Examples, but a high removal rate was still maintained.

### <EVALUATION OF PROPERTY TO ELIMINATE THE DIFFERENCE IN LEVEL>

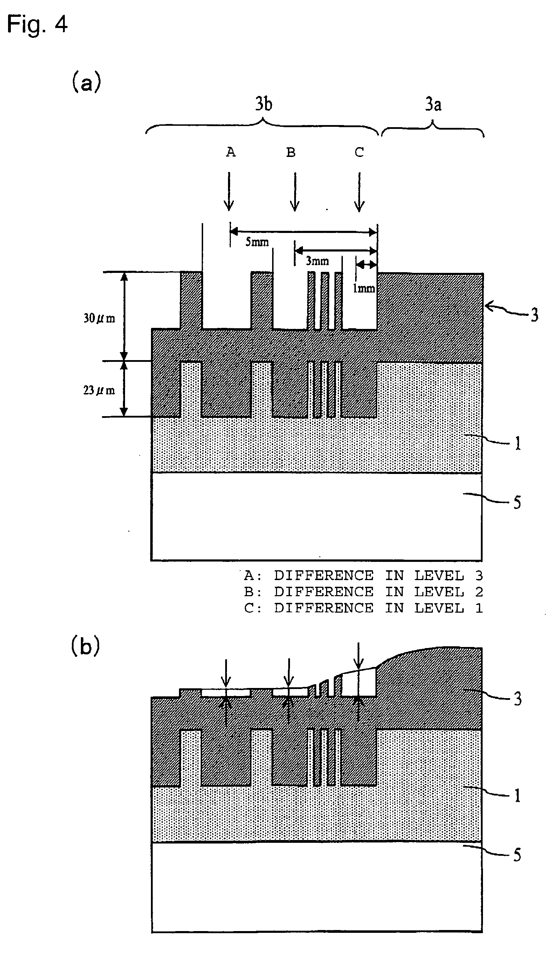

Fig. 4(a) is a schematic sectional view showing a part of an object to be polished before polishing. Further, Fig. 4(b) is a schematic sectional view showing a part of an object to be polished in the middle of polishing. In these Figs., a boundary portion is shown, which is a boundary of a broad surface portion (3a in Fig. 4(a)) of a substrate where no wiring trench is formed, and a portion (3b in Fig. 4(a)) where wiring trenches having depths of 23 µm are formed. A copper film having a thickness of 30 µm is formed on the entire surface. Further, in these Figs., portions having the same symbols as Fig. 1 to Fig. 3 are the same. Further, for the description, the scale ratio of the vertical direction and the horizontal direction is changed.

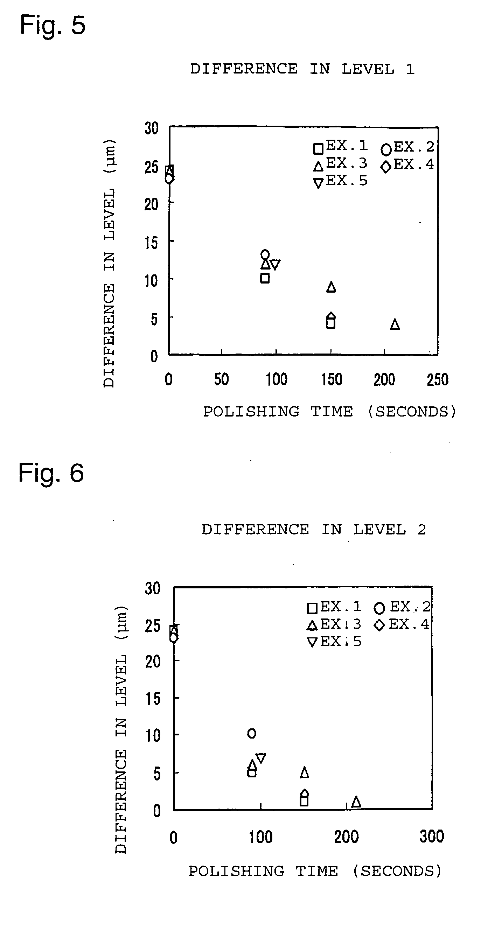

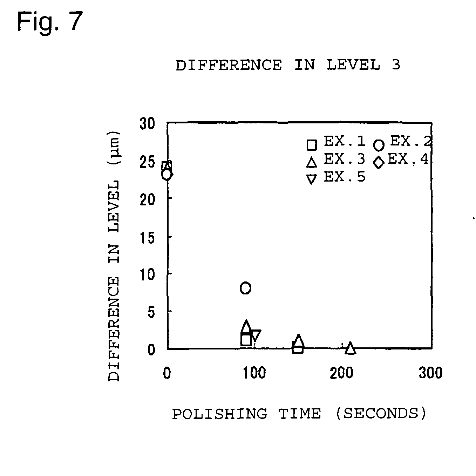

Table 3 and Fig. 5 to Fig. 7 show the results of the evaluation of the property to eliminate the difference in level. Further, the evaluation was carried out with respect to three points (difference in level 1, 2, and 3) of an object to be polished shown in Fig. 4(a) by measuring the difference in level by apparatus for measuring difference in level (DEKTAK V200Si, manufactured by Veeco). Further, in Fig. 4(a), the numerical values shown by arrows in the line width direction (the horizontal direction of the Fig.), are distances from the pattern 3a to the measuring points of the respective differences in level.

Further, for the height of the difference in level, a profile in the vicinity of the measuring point of each different in level was obtained, and the height was meant for the difference between the bottom of the difference in level corresponding to the wiring trench and a line connecting corners at both ends of the difference in level corresponding to the surface of the substrate, at the measuring point of each difference in level.

Further, in Table 3, the unit for the difference in level 1, 2 or 3 is µm. Further, a slash mark (\) means that no measurement of the difference in level in the corresponding polishing time, was carried out.

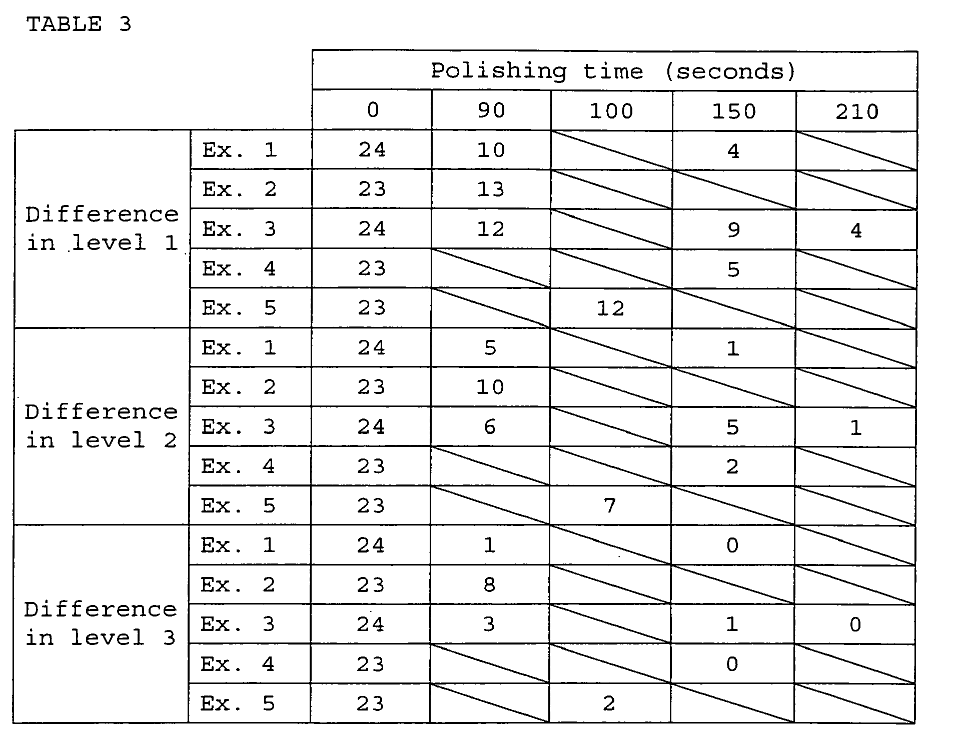

Generally, the difference in level most difficult to eliminate is a difference in level adjacent to a broad surface portion of a substrate where no wiring trench is formed. In Fig. 4(a), the difference in level most difficult to eliminate is the difference in level 1, followed by the difference in level 2 and then by the difference in level 3.

As shown in Table 3 and Fig. 5 to Fig. 7, in Example 1 of the present invention, at each difference in level, the difference in level was eliminated by polishing for a short period of time, as compared with Examples 2 and 3 as Comparative Examples. Example 4 is an Example of a polishing compound having a composition which contains no trishydroxymethyl aminomethane. Further, Example 5 is an Example of a polishing compound having a composition which contains no trishydroxymethyl aminomethane and contains carbonate ions instead of chlorine ions. In these Examples, in the same manner as in Example 1, at each difference in level, the difference in level was eliminated by polishing for a short period of time.

### INDUSTRIAL APPLICABILITY

The polishing compound of the present invention can satisfy both a high removal rate of an object to be polished and an excellent property to eliminate the difference in level, and when polishing a wiring metal, it can increase the removal rate while suppressing an increase of the wiring resistance. Further, according to the polishing method of the present invention, polishing is carried out by chemical and mechanical actions, whereby it is possible to reduce formation of scratches on the wiring metal as compared with mechanical polishing, and thus the method is industrially useful.

The entire disclosure of Japanese Patent Application No. 2006-151477 filed on May 31, 2006 including specification, claims, drawings and summary is incorporated herein by reference in its entirety.

## Claims

1. A polishing compound which comprises abrasive particles, an oxidizing agent, ammonium ions, polyvalent carboxylate ions, at least one chelating agent selected from the group consisting of pentaethylenehexamine, triethylenetetramine and tetraethylenepentamine, and an aqueous medium.

2. The polishing compound according to Claim 1, wherein the above chelating agent has a concentration of from 0.0005 mol/kg to 0.05 mol/kg.

3. The polishing compound according to Claim 1 or 2, wherein the above ammonium ions have a concentration of at least 0.3 mol/kg.

4. The polishing compound according to any one of Claims 1 to 3, wherein the above polyvalent carboxylate ions have a concentration of from 0.05 mol/kg to 0.5 mol/kg.

5. The polishing compound according to any one of Claims 1 to 4, wherein the above polyvalent carboxylate ions include citrate ions.

6. The polishing compound according to any one of Claims 1 to 5, wherein the above abrasive particles are α-alumina.

7. The polishing compound according to any one of Claims 1 to 6, wherein the above oxidizing agent is hydrogen peroxide.

8. The polishing compound according to any one of Claims 1 to 7, which further contains at least one type of ions selected from the group consisting of carbonate ions, hydrogencarbonate ions, sulfate ions and acetate ions.

9. The polishing compound according to any one of Claims 1 to 8, which has a pH of from 6 to 10.

10. The polishing compound according to any one of Claims 1 to 9, which further contains a copper surface protective agent.

11. A polishing method which comprises polishing a wiring metal by using the polishing compound as defined in any one of Claims 1 to 10.

12. The polishing method according to Claim 11, wherein the above wiring metal is either one of copper and a copper alloy.

13. The polishing method according to Claim 11 or 12, wherein the above wiring metal is provided on a resin substrate.
